# EUROPÄISCHE PATENTSCHRIFT

(11) **EP 1 685 265 B1**
(45) Veröffentlichungstag und Bekanntmachung des Hinweises auf die Patenterteilung: **17.10.2007**
(21) Anmeldenummer: 04725305.9
(22) Anmeldetag: 02.04.2004
(51) Int. Cl.: C22C 21/00, B32B 15/01

(54) **GLEITLAGERVERBUNDWERKSTOFF MIT AUFGESPUTTERTER GLEITSCHICHT**
PLAIN BEARING COMPOSITE MATERIAL COMPRISING A SPUTTERED BEARING COATING
MATERIAU COMPOSITE POUR COUSSINET LISSE A COUCHE DE GLISSEMENT APPLIQUEE PAR PULVERISATION CATHODIQUE

(30) Priorität: 21.11.2003 DE 10355547
(43) Veröffentlichungstag der Anmeldung: 02.08.2006
(73) Patentinhaber: KS Gleitlager GmbH, 68789 St. Leon-Rot (DE)
(72) Erfinder: CASPERS, Gerhard, 76669 Bad Schönborn (DE); SCHUBERT, Werner, 69168 Wiesloch (DE); DEICKE, Klaus, 74257 Untereisesheim (DE); GERLACH, Friedhelm, 26810 Westoverleding (DE)
(74) Vertreter: Friz, Oliver
(86) Internationale Anmeldenummer: PCT/EP2004/003494
(87) Internationale Veröffentlichungsnummer: WO 2005/052202

(56) Entgegenhaltungen:
- EP-A- 0 265 937
- WO-A-96/33352
- DE-A- 3 729 414
- DE-A- 4 328 921
- DE-A- 19 730 549
- DE-C- 10 056 579
- US-A- 5 445 896

## Beschreibung

Die vorliegende Erfindung betrifft einen Gleitlagerverbundwerkstoff mit einer Stahlrückenschicht, einer darauf angegossenen, aufgesinterten oder aufplattierten Trägerschicht aus Bronze oder Messing und einer auf die Trägerschicht oder eine Zwischenschicht aufgesputterten Gleitschicht aus einem Gleitschichtmaterial auf Aluminium/Zinn/Kupfer-Basis.

Gleitlagerverbundwerkstoffe insbesondere zur Herstellung von Gleitlagerschalen für motorische Anwendungen, insbesondere zur Lagerung der Kurbelwelle oder als Pleuellagerschalen, mit einer aufgesputterten, d.h. im Kathodenzerstäubungsverfahren erzeugten Gleitschicht auf Aluminium/Zinn-Basis sind bekannt. Beispielsweise fertigt und vertreibt die Anmelderin Gleitlagerschalen für motorische Anwendungen mit einer aufgesputterten Gleitschicht der Zusammensetzung AlSn20 und AlSn20Cul. Die Anmelderin hat auch eine Produktbeschreibung "PVD-Beschichtete Hochleistungsgleitlager" veröffentlicht, die das Sputtern von Lagerschalen grundlegend beschreibt.

Ausgehend von Gleitlagerverbundwerkstoffen für geringere Beanspruchungen mit einer galvanisch abgeschiedenen Gleitschicht oder mit aufgegossener oder aufplattierter Gleitschicht auf Aluminium/Zinn-Basis, die eine Härte von etwa 35 bis 45 HV 0,002 aufwiesen, war man Ende der 80er Jahre bestrebt, Gleitlagerverbundwerkstoffe für höhere Belastungen zu fertigen. Es wurde seinerzeit festgestellt, dass durch aufgesputterte Gleitschichten, die dann Härten von 70 bis 90 HV 0,002 aufwiesen, höhere Belastbarkeiten und verbesserte Verschleißwiderstände erreicht werden konnten.

Man realiserte sehr rasch, dass eine weitere Steigerung der Härte von aufgesputterten Gleitschichten mit einer unerwünschten Versprödung des Gleitschichtmaterials einhergeht, was zum raschen Ausfall eines aus einem solchen Gleitlagerverbundwerkstoff hergestellten Gleitlagers führt. Insofern haben sich Gleitlagerverbundwerkstoffe mit einer Härte der aufgesputterten Gleitschicht im Bereich von 80 bis höchstens 100 HV 0,002 der gattungsgemäßen Art etabliert.

Wenn EP 0 272 447 A2 mit Zeitrang 1986 eine Härtesteigerung unter Einsatz einer Sauerstoffatmosphäre auf Werte während eines Zwischenzustands vor einer Wärmebehandlung von 113 HV am Lagerscheitel und 45 HV an den Enden der Lagerschale offenbart, wobei diese Werte dann nach einer Wärmebehandlung auf etwa 92 HV 0,002 herabgesetzt wurden, so bringt dies zum damaligen Zeitpunkt zwar das Bestreben nach einer Härtesteigerung zum Ausdruck. Zum heutigen Tage jedenfalls besteht in der Fachwelt das Bestreben nach moderaten Härten im Bereich von 70 bis 100 HV 0,002 bei gattungsgemäßen Gleitlagerverbundwerkstoffen.

DE 36 29 451 C2 offenbart einen gattungsgemäßen Gleitlagerverbundwerkstoff und erwähnt eine AlSn20Cul-Legierung als Gleitschicht sowie eine AlSi4Sn15Pb10-Legierung. Auch in dieser Druckschrift kommt das heute überholte Bestreben nach extremen Härten der Gleitschicht zum Ausdruck.

Mit EP 0 265 937 A2 der Anmelderin wurde bereits erkannt, dass in Verbindung mit AlSn5Cu, AlSn10Cu, AlSn20Cu, AlSn30Cu, AlSn40Cu, Alsn10Pb10Cu-Gleitschichtzusammensetzungen mit Endhärten des aufgesputterten Gleitschichtmaterials von 75 bis 97,5 HV 0,002 erreicht werden können, die sich (noch) als geeignet erwiesen. Auch nach dieser Druckschrift sollte unter Verwendung einer Sauerstoffatmosphäre der Anteil oxidischer Bestandteile in dem Gleitschichtmaterial und damit die Härte gegenüber Werten von ca. 60 HV 0,002 erhöht werden.

Der aus EP 0 300 993 A1 bekannte stengelförmige Schichtaufbau bei gesputterten Gleitschichten hat sich in der Praxis als völlig ungeeignet erwiesen, da die Stengelform mit einer starken Sprödheit einhergeht, und zwar unabhängig von der konkreten Zusammensetzung des Gleitschichtmaterials.

Aus WO 96/33352 ist eine Gleitlagerschale für motorische Anwendungen aus einem Gleitlagerverbundwerkstoff mit einer Stahlrückenschicht, einer Trägerschicht aus Bleibronze und einer darauf durch Elektronenstrahlbedampfung aufgebrachten Gleitschicht aus einer AlSn20Cu0,25-Legierung bekannt. Es findet sich in dieser Druckschrift der pauschale Hinweis, dass das Gleitschichtmaterial 15 bis 35 Gew.-% Zinn und 0,1 bis 3,0 Gew.-% Kupfer und Restaluminium aufweisen könne. Das einzige Ausführungsbeispiel offenbart jedoch die genannte AlSn20Cu0,25-Zusammensetzung.

Es hat sich gezeigt, dass eine durch Elektronenstrahlbedampfung aufgebrachte Gleitschicht ein weniger geeignetes metallurgisches Gefüge und eine geringere Belastbarkeit aufweist als eine im Kathodenzerstäubungsverfahren aufgebrachte, also gesputterte Gleitschicht.

US 5,445,896 offenbart einen gattungsgemäßen Gleitlagerverbundwerkstoff, dessen mögliche Zusammensetzung angegeben ist mit 10 bis 8-0 Gew.-% Sn, 0,1 bis 5 Gew.-% Cu, 0,05 bis 3 Gew.-% Sb, Rest A1, gegebenenfalls bis zu 10 Gew.-% Pb und Bi und ferner gegebenenfalls bis zu 5 Gew.-% Si. Alle Ausführungsbeispiele enthalten 1 Gew.-% Kupfer und 0,5 Gew.-% Antimon. Die in der Tabelle 1 angegebenen Härtewerte liegen überwiegend unter 100 HV.

Der vorliegenden Erfindung liegt die Aufgabe zugrunde, einen gattungsgemäßen Gleitlagerverbundwerkstoff zur Herstellung von Gleitlagerelementen, insbesondere Gleitlagerschalen für motorische Anwendungen, dahingehend zu verbessern, dass eine noch höhere Belastbarkeit und ein verbesserter Verschleißwiderstand erreicht wird, um ein hieraus hergestelltes Gleitlagerelement an die immer weiter steigenden Anforderungen bei modernen Brennkraftmaschinen anzupassen.

Diese Aufgabe wird bei einem Gleitlagerverbundwerkstoff der genannten Art erfindungsgemäß dadurch gelöst, dass die Zusammensetzung des Gleitschichtmaterials AlSn(22-30)Cu(2,3-2,8) ist, gegebenenfalls mit jeweils bis zu 2 Gew.-% Ni, Si, Mn und verunreinigungsbedingten Bestandteilen bis jeweils 0,5 Gew.-% in der Summe jedoch nicht höher als 1 Gew.-%, und dass die Härte der Gleitschicht 110 - 150 HV 0,002 beträgt.

Mit der vorliegenden Erfindung wurde in überraschender Weise festgestellt, dass bei einer Erhöhung des Kupfergehalts in den beanspruchten Bereich und bei einem Zinngehalt innerhalb des beanspruchten Bereichs eine Steigerung der Belastbarkeit und des Verschleißwiderstands erreicht werden kann, indem die Härte der Gleitschicht in den Bereich von 110 bis 150 HV 0,002 angehoben werden kann, ohne dass hierdurch eine Versprödung des Gleitschichtmaterials hervorgerufen wird. Man war seither davon ausgegangen, dass bei gattungsgemäßen Gleitlagerverbundwerkstoffen oberhalb von 100 HV 0,002 kein brauchbarer Gleitlagerverbundwerkstoff bzw. kein brauchbares hieraus hergestelltes Gleitlagerelement für motorische Anwendungen erhalten werden kann, da mit der Steigerung der Härte das Anpassungsverhalten und die Einbettfähigkeit von mikroskopischen Störkörpern in das Gleitschichtmaterial nicht mehr in dem erforderlichen Maße gegeben sei. Weiter war man davon ausgegangen, dass die Haftfestigkeit der aufgesputterten Gleitschicht nicht mehr ausreicht, um ein Ablösen zu verhindern. Es wurde nun in überraschender Weise festgestellt, dass dies bei der beanspruchten Zusammensetzung des Gleitschichtmaterials nicht der Fall ist, sondern dass sehr hohe Härten, die zu guten Verschleißwiderständen führen, erreicht werden können, wobei eine dennoch ausreichende Duktilität für die Einbettung von Fremdkörpern vorhanden ist, was nicht zu erwarten war.

Es existiert eine sehr einfach durchführbare Prüfmethode, die Aufschluss darüber geben kann, ob ein Gleitlagerverbundwerkstoff der gattungsgemäßen Art von vornherein für übliche Belastbarkeiten, wie sie bei Brennkraftmaschinen auftreten, geeignet ist oder nicht. Von einer hinreichenden Duktilität der Gleitschicht kann dann ausgegangen werden, wenn eine Ritzung der Gleitschicht mit einer feinen Klinge, beispielsweise eines Teppichmessers, bis auf die Trägerschicht hindurch zu einer verdrängenden Aufwerfung entlang der Ritzung führt, nicht jedoch zu einem Abplatzen von Gleitschichtpartikeln, wie dies bei einer Versprödung des Gleitschichtmaterials der Fall wäre.

Entgegen der in der Fachwelt herrschenden Ansicht, dass gattungsgemäße Gleitlagerverbundwerkstoffe mit moderaten Härten im Bereich von 70 bis maximal 100 HV ausgebildet werden sollten, wurde mit der vorliegenden Erfindung festgestellt, dass bei der beanspruchten Zusammensetzung bei demgegenüber höheren Härten im beanspruchten Bereich eine zufriedenstellende Duktilität des Gleitschichtmaterials angetroffen wird, die für ein gutes Einbettverhalten bzw. Anpassungsverhalten des Gleitschichtmaterials im Betrieb verantwortlich ist. Dies ist aber Voraussetzung für einen dauerhaft guten Verschleißwiderstand und eine dauerhaft hohe Belastbarkeit.

Bevorzugte Zusammensetzungen des Gleitschichtmaterials und bevorzugte Härten der Gleitschicht sind in den Unteransprüchen angegeben.

Insbesondere erweist sich ein bleifreies Gleitschichtmaterial oder ein insgesamt bleifreier Gleitlagerverbundwerkstoff als vorteilhaft.

Bei einer bevorzugten Ausführungsform des erfindungsgemäßen Gleitlagerverbundwerkstoffs besteht die Zusammensetzung des Gleitschichtmaterials aus einer AlSn (22-30) Cu (2,3-2,8)-Legierung, allenfalls mit verunreinigungsbedingten Bestandteilen, vorzugsweise jeweils geringer als 0,05 Gew.-%.

Eine bevorzugte Zusammensetzung des erfindungsgemäßen Gleitschichtmaterials ist AlSn25Cu2,5.

Es hat sich gezeigt, dass ein erfindungsgemäßer Gleitlagerverbundwerkstoff bzw. ein hieraus hergestelltes Gleitlagerelement gegenüber einem gattungsgemäßen Verbundwerkstoff aus AlSn20Cul-Gleitschichtmaterial einen überlegenen Verschleißwiderstand und zusätzlich eine höhere Belastbarkeit aufweist. Trotz einer Härte im beanspruchten Bereich weist die Gleitschicht bzw. das Gleitschichtmaterial eine ausreichende Duktilität für ein gutes Einbettverhalten und Anpassungsverhalten auf, so dass der erfindungsgemäße Werkstoff insgesamt höher belastbar und verschleißfester ist als bekannte Werkstoffe oder daraus hergestellte Gleitelemente.

## Patentansprüche

1. Gleitlagerverbundwerkstoff mit einer Stahlrückenschicht, einer darauf aufgegossenen, aufgesinterten oder aufplattierten Trägerschicht aus Bronze oder Messing und einer auf die Trägerschicht oder eine Zwischenschicht aufgesputterten Gleitschicht aus einem Gleitschichtmaterial auf Aluminium/Zinn/Kupfer-Basis, **dadurch gekennzeichnet, dass** die Zusammensetzung des Gleitschichtmaterials AlSn(22 - 30)Cu(2,3-2,8) ist, gegebenenfalls mit jeweils bis zu 2 Gew.-% Ni, Si, Mn und verunreinigungsbedingten Bestandteilen bis jeweils 0,5 Gew.-% in der Summe jedoch nicht höher als 1 Gew.-%, und dass die Härte der Gleitschicht 110 - 150 HV 0,002 beträgt.

2. Gleitlagerverbundwerkstoff nach Anspruch 1, **dadurch gekennzeichnet, dass** das Gleitschichtmaterial bleifrei ist.

3. Gleitlagerverbundwerkstoff nach Anspruch 2, **dadurch gekennzeichnet, dass** der Gleitlagerverbundwerkstoff bleifrei ist.

4. Gleitlagerverbundwerkstoff nach Anspruch 1, 2 oder 3, **dadurch gekennzeichnet, dass** der Gleitlagerverbundwerkstoff antimonfrei ist.

5. Gleitlagerverbundwerkstoff nach einem der vorstehenden Ansprüche, **dadurch gekennzeichnet, dass** die Zusammensetzung des Gleitschichtmaterials AlSn (22 - 28)Cu(2,3-2,8) ist.

6. Gleitlagerverbundwerkstoff nach Anspruch 5, **dadurch gekennzeichnet, dass** die Zusammensetzung des Gleitschichtmaterials AlSn(23 - 28) Cu (2,3-2,8) ist.

7. Gleitlagerverbundwerkstoff nach Anspruch 6, **dadurch gekennzeichnet, dass** die Zusammensetzung des Gleitschichtmaterials AlSn(23 - 27)Cu(2,4-2,7) ist.

8. Gleitlagerverbundwerkstoff nach einem der vorstehenden Ansprüche, **dadurch gekennzeichnet, dass** die Härte der Gleitschicht 110 - 140 HV 0,002 beträgt.

9. Gleitlagerverbundwerkstoff nach Anspruch 8, **dadurch gekennzeichnet, dass** die Härte der Gleitschicht 110 - 130 HV 0,002 beträgt.

10. Gleitlagerverbundwerkstoff nach Anspruch 9, **dadurch gekennzeichnet, dass** die Härte der Gleitschicht 115 - 130 HV 0,002 beträgt.

11. Gleitlagerverbundwerkstoff nach einem der vorstehenden Ansprüche, **dadurch gekennzeichnet, dass** die Trägerschicht von einer CuPb(8-25)-Sn(2-12)-Legierung oder von einer CuZn(20-32)-Legierung gebildet ist.

12. Gleitlagerelement, insbesondere Gleitlagerschale für motorische Anwendungen, Kurbelwellenlagerschale, Pleuellagerschale, hergestellt aus einem Gleitlagerverbundwerkstoff nach einem oder mehreren der vorstehenden Ansprüche.

## Claims

1. Plain bearing composite material comprising a steel back layer, a carrier layer of bronze or brass which is cast, sintered or cladded thereon, and a sliding layer of a sliding layer material based on aluminium/tin/copper, which is sputtered onto the carrier layer or an intermediate layer, **characterised in that** the composition of the sliding layer material is AlSn(22-30)Cu(2.3-2.8), optionally comprising up to 2 % by weight of each of Ni, Si, Mn, and impurity-related components of up to 0.5 % by weight each, but in total not more than 1 % by weight, and **in that** the hardness of the sliding layer is 110-150 HV 0.002.

2. Plain bearing composite material according to claim 1, **characterised in that** the sliding layer material is lead-free.

3. Plain bearing composite material according to claim 2, **characterised in that** the plain bearing composite material is lead-free.

4. Plain bearing composite material according to claim 1, 2 or 3, **characterised in that** the plain bearing composite material contains no antimony.

5. Plain bearing composite material according to any one of the preceding claims, **characterised in that** the composition of the sliding layer material is AlSn(22-28)Cu(2.3-2.8).

6. Plain bearing composite material according to claim 5, **characterised in that** the composition of the sliding layer material is AlSn(23-28)Cu(2.3-2.8).

7. Plain bearing composite material according to claim 6, **characterised in that** the composition of the sliding layer material is AISn(23-27)Cu(2.4-2.7).

8. Plain bearing composite material according to any one of the preceding claims, **characterised in that** the hardness of the sliding layer is 110-140 HV 0.002.

9. Plain bearing composite material according to claim 8, **characterised in that** the hardness of the sliding layer is 110-130 HV 0.002.

10. Plain bearing composite material according to claim 9, **characterised in that** the hardness of the sliding layer is 115-130 HV 0.002.

11. Plain bearing composite material according to any one of the preceding claims, **characterised in that** the carrier layer is formed by a CuPb(8-25)Sn(2-12) alloy or by a CuZn(20-32) alloy.

12. Plain bearing element, in particular a plain bearing shell for automotive applications, a crankshaft bearing shell or a connecting rod bearing shell made of a plain bearing composite material according to one or more of the preceding claims.

## Revendications

1. Matériau composite pour palier lisse, avec une couche inférieure en acier, une couche support en bronze ou en laiton coulée, frittée ou plaquée par dessus cette couche inférieure, ainsi qu'une couche de glissement faite d'un matériau de couche de glissement à base d'aluminium/étain/ cuivre déposée par pulvérisation cathodique sur la couche support ou sur une couche intermédiaire, **caractérisé en ce que** la composition du matériau de couche de glissement est AlSn(22-30)Cu(2,3-2,8), le cas échéant avec jusqu'à 2% en poids de chacun des éléments Ni, Si, Mn et jusqu'à 0,5% en poids chacun de constituants liés à des impuretés mais dont la somme ne dépasse pas 1% en poids, et **en ce que** la dureté de la couche de glissement se situe dans la plage de 110 à 150 HV 0,002.

2. Matériau composite pour palier lisse selon la revendication 1, **caractérisé en ce que** le matériau de couche de glissement ne contient pas de plomb.

3. Matériau composite pour palier lisse selon la revendication 2, **caractérisé en ce que** le matériau composite pour palier lisse ne contient pas de plomb.

4. Matériau composite pour palier lisse selon les revendications 1, 2 ou 3, **caractérisé en ce que** le matériau composite pour palier lisse ne contient pas d'antimoine.

5. Matériau composite pour palier lisse selon l'une des revendications précédentes, **caractérisé en ce que** la composition du matériau de couche de glissement est AlSn(22-28)Cu(2,3-2,8).

6. Matériau composite pour palier lisse selon la revendication 5, **caractérisé en ce que** la composition du matériau de couche de glissement est AlSn(23-28)Cu(2,3-2,8).

7. Matériau composite pour palier lisse selon la revendication 6, **caractérisé en ce que** la composition du matériau de couche de glissement est AlSn(23-27)Cu(2,4-2,7).

8. Matériau composite pour palier lisse selon l'une des revendications précédentes, **caractérisé en ce que** la dureté de la couche de glissement se situe dans la plage de 110 à 140 HV 0,002.

9. Matériau composite pour palier lisse selon la revendication 8, **caractérisé en ce que** la dureté de la couche de glissement se situe dans la plage de 110 à 130 HV 0,002.

10. Matériau composite pour palier lisse selon la revendication 9, **caractérisé en ce que** la dureté de la couche de glissement se situe dans la plage de 115 à 130 HV 0,002.

11. Matériau composite pour palier lisse selon l'une des revendications précédentes, **caractérisé en ce que** la couche support est faite d'un alliage CuPb(8-25)Sn(2-12) ou d'un alliage CuZn(20-32).

12. Élément de palier lisse, en particulier coquille de palier lisse utilisable dans des moteurs, coquille de coussinet de vilebrequin, coquille de coussinet de bielle, fabriqué dans un matériau composite pour palier lisse selon l'une ou plusieurs des revendications précédentes.
